# EUROPEAN PATENT APPLICATION

(11) **EP 4 708 354 A1**
(43) Date of publication of application: **11.03.2026**
(21) Application number: 24800069.7
(22) Date of filing: 19.04.2024
(51) Int. Cl.: H01L 21/306

(54) **SUBSTRATE PROCESSING METHOD**

(30) Priority: 02.05.2023 JP 2023075947
(71) Applicant: SCREEN Holdings Co., Ltd., Kyoto-shi, Kyoto 602-8585 (JP)
(72) Inventor: IWAHATA, Shota, Kyoto-shi, Kyoto 602-8585 (JP); SASAKI, Kazunari, Kyoto-shi, Kyoto 602-8585 (JP); HEMMI, Takashi, Kyoto-shi, Kyoto 602-8585 (JP); OTA, Takashi, Kyoto-shi, Kyoto 602-8585 (JP); NAKANO, Teppei, Kyoto-shi, Kyoto 602-8585 (JP)
(74) Representative: Kilian Kilian & Partner mbB
(86) International application number: PCT/JP2024/015534
(87) International publication number: WO 2024/228338

(57) **Abstract**

A substrate processing method includes a substrate rotating step of rotating a substrate, having a principal surface that has been ground or polished for substrate thinning, around a rotational axis perpendicular to the principal surface, a first etching step of supplying a first etching liquid that contains hydrofluoric acid and nitric acid to the principal surface during execution of the substrate rotating step, and a second etching step of supplying a second etching liquid that contains TMAH (tetramethylammonium hydroxide) to the principal surface during execution of the substrate rotating step after the first etching step. A second etching parameter applied in the second etching step is adjusted such as to flatten a first surface profile formed on the principal surface resulted by the first etching step.

## Description

### Related Application

This application claims priority to Japanese Patent Application No. 2023-75947 filed on May 2, 2023, the entire content of which is incorporated herein by reference in its entirety.

### Technical Field

The present invention relates to a substrate processing method.

### Background Art

Patent Literature 1 discloses a substrate processing for thinning a silicon wafer by an etching liquid.

### Citation List

### Patent Literature

Patent Literature 1: Japanese Patent Application Publication No. 2012-199408

### Summary of Invention

### Technical Problem

An example embodiment of the present invention provides a substrate processing method by which a surface profile of a principal surface of a substrate can be flattened while processing the principal surface of the substrate by an etching liquid and thinning the substrate. Solution to Problem

An example embodiment of the present invention provides a substrate processing method having features listed exemplarily below.
1. A substrate processing method including:
   a substrate rotating step of rotating a substrate, having a principal surface that has been ground or polished for substrate thinning, around a rotational axis perpendicular to the principal surface,
   a first etching step of supplying a first etching liquid that contains hydrofluoric acid and nitric acid to the principal surface during execution of the substrate rotating step, and
   a second etching step of supplying a second etching liquid that contains TMAH (tetramethylammonium hydroxide) to the principal surface during execution of the substrate rotating step after the first etching step,
   wherein a second etching parameter applied in the second etching step is adjusted such as to flatten a first surface profile formed on the principal surface resulted by the first etching step.
2. The substrate processing method according to Clause 1, wherein
   a first etching profile with respect to the principal surface by the first etching step is variable by variable setting of a first etching parameter applied in the first etching step,
   a second etching profile with respect to the principal surface by the second etching step is variable by variable setting of the second etching parameter applied in the second etching step, and
   the first etching parameter and the second etching parameter are adjusted such that a second surface profile formed on the principal surface resulted by performing the first etching step and the second etching step on the substrate successively has a flatness not more than a predetermined value.
3. The substrate processing method according to Clause 2, wherein the first etching parameter and the second etching parameter are adjusted such that a synthetic etching profile in which the first etching profile and the second etching profile are overlapped has a flatness not more than a predetermined value.
4. The substrate processing method according to Clause 2, wherein the first etching parameter and the second etching parameter are adjusted such that a synthetic surface profile in which an initial surface profile of the principal surface before the first etching step, the first etching profile and the second etching profile are overlapped has a flatness not more than a predetermined value.
5. The substrate processing method according to any one of Clauses 2 to 4, wherein the first etching step includes a first scanning step of moving a liquid landing position of the first etching liquid on the principal surface such that a distance between the liquid landing position and the rotational axis changes with elapse of time, and
   the first etching parameter includes a first scanning parameter that defines the change in the liquid landing position in the first scanning step.
6. The substrate processing method according to any one of Clauses 1 to 5, wherein
   the second etching step includes a second scanning step of moving a liquid landing position of the second etching liquid on the principal surface such that a distance between the liquid landing position and the rotational axis changes with elapse of time, and
   the second etching parameter includes a second scanning parameter that defines the change in the liquid landing position in the second scanning step.
7. The substrate processing method according to any one of Clauses 1 to 6, wherein a second surface profile of the principal surface after the second etching step has a flatness of not more than 1.5 µm.
8. The substrate processing method according to any one of Clauses 1 to 7, wherein the principal surface is a surface where a silicon layer is exposed.
9. The substrate processing method according to Clause 8, wherein the substrate has a silicon germanium layer and the silicon layer that is laminated on the silicon germanium layer.
10. The substrate processing method according to Clause 9, further including a third etching step of supplying a third etching liquid that contains ammonium hydroxide to the principal surface during execution of the substrate rotating step after the second etching step.
11. The substrate processing method according to Clause 10, wherein a layer thickness of the silicon layer at an end of the second etching step is not more than 4 µm (and not less than 2.5 µm).
12. The substrate processing method according to Clause 10 or 11, wherein a layer thickness of the silicon germanium layer at an end of the third etching step is not more than 10 nm (and not less than 5 nm).
13. The substrate processing method according to any one of Clauses 10 to 12, wherein a concentration of the ammonium hydroxide in the third etching liquid and a temperature of the third etching liquid are set such that, in the third etching step, an etching rate of the silicon layer is not less than 200 nm/minute (more preferably, not less than 300 nm/minute) and an etching selection ratio of silicon with respect to silicon germanium is not less than 150 (more preferably, not less than 250).

The above and yet other objects, features, and effects of the present invention will become more apparent from the following description of example embodiments made with reference to the attached drawings.

### Brief Description of Drawings

[FIGS. 1A-1B] FIG. 1A and FIG. 1B show an example of a manufacturing process of a semiconductor device to which a substrate processing method according to an example embodiment of the present invention is applied.
[FIG. 2] FIG. 2 shows an arrangement example of a substrate processing apparatus arranged to execute a precision thinning stage of the substrate processing method.
[FIG. 3] FIG. 3 is a block diagram for describing an electrical arrangement of the substrate processing apparatus.
[FIGS. 4A-4I] FIG. 4A to FIG. 4I show examples of various etching profiles that can be set by adjustment of etching parameters.
[FIG. 5] FIG. 5 is a flow diagram showing an example of substrate processing of the precision thinning stage.
[FIGS. 6A-6C] FIG. 6A, FIG. 6B, and FIG. 6C show conditions of main steps of the substrate processing.
[FIGS. 7A-7C] FIG. 7A shows an example of an initial surface profile before a first etching step is started. FIG. 7B represents an example of a surface profile (a first surface profile) after the first etching step. FIG. 7C shows an example of a surface profile (a second surface profile) after a second etching step.
[FIG. 8] FIG. 8 shows an example of a flow of the adjustment of the etching parameters.
[FIG. 9] FIG. 9 shows another example of the flow of the adjustment of the etching parameters.
[FIG. 10A] FIG. 10A shows, for a case of etching silicon by ammonia water, results of examining relationships of etching selection ratio (left ordinate) and etching rate (right ordinate) versus concentration of ammonium hydroxide (ammonium hydroxide : water).
[FIG. 10B] FIG. 10B shows, for a case of etching silicon by ammonia water with a concentration of ammonium hydroxide : water = 1:20, results of examining relationships of etching selection ratio (left ordinate) and etching rate (right ordinate) versus temperature of the ammonia water.

### Description of Embodiments

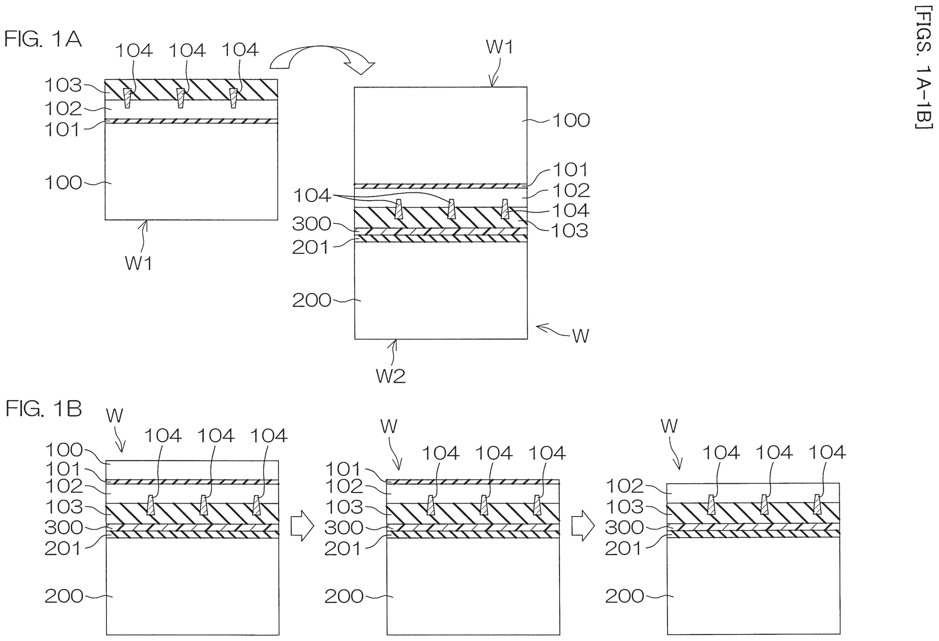

FIG. 1A and FIG. 1B show an example of a manufacturing process of a semiconductor device to which a substrate processing method according to an example embodiment of the present invention is applied. A first silicon wafer W1 includes a silicon layer 100 constituted of a silicon substrate, an etching stop layer 101, and a silicon active layer 102. The etching stop layer 101 is formed on a surface of the silicon layer 100 and the silicon active layer 102 is formed on the etching stop layer 101. The etching stop layer 101 is, for example, a silicon germanium (SiGe) layer and the silicon active layer 102 is a silicon epitaxial growth layer that has been epitaxially grown from the etching stop layer 101. A transistor or other device (not shown) is formed in the silicon active layer 102. A multilayer wiring layer 103 is formed on the silicon active layer 102. The multilayer wiring layer 103 is arranged by laminating a wiring layer and an interlayer insulating layer (both not shown). Buried power rails 104 (BPR) are disposed across the silicon active layer 102 and the multilayer wiring layer 103.

The first silicon wafer W1 is bonded to a second silicon wafer W2 serving as a carrier substrate. More specifically, an exposed surface of the first silicon wafer W1 at the multilayer wiring layer 103 side and a principal surface of the second silicon wafer W2 are adhered via an adhesive layer 300 and a bonded substrate W is made thereby. The adhesive layer 300 may include, for example, an SiCN layer. The second silicon wafer W2 typically includes a silicon substrate 200 and an insulating layer 201 formed on its front surface. A bonding surface of the second silicon wafer W2 is thus typically a front surface of the insulating layer 201. Typically, the front surface of the insulating layer 201 and a front surface of the multilayer wiring layer 103 of the first silicon wafer W1 are adhered via the adhesive layer 300.

An exposed principal surface of the first silicon wafer W1 in the bonded substrate W thus made is the principal surface to be processed and a thinning processing for thinning the substrate W is performed on the principal surface. The thinning processing is a processing for removing the silicon layer 100 (the silicon substrate) of the first silicon wafer W1 and exposing the etching stop layer 101. That is, the object of the thinning processing is the silicon layer 100 (the silicon substrate). By the etching stop layer 101 being removed after the thinning processing, the silicon active layer 102 is left. The second silicon wafer W2 is used, for example, to construct a power delivery network (PDN) at an opposite side to (a rear surface side of) the silicon active layer 102.

The thinning processing includes a high-speed thinning stage and a precision thinning stage. The high-speed thinning stage includes a grinding stage and further includes a polishing stage as necessary. The grinding stage is, for example, a stage of thinning the silicon layer 100 (the silicon substrate) of approximately 775 µm thickness to approximately 50 µm thickness by a grinding processing by a grinder. The polishing stage is a stage of polishing the principal surface that has been roughened in the grinding stage and is typically a CMP (chemomechanical polishing) processing. By the polishing stage, for example, the silicon layer 100 is thinned from approximately 50 µm thickness to approximately 49 µm thickness. The silicon layer 100 of the remaining 49 to 50 µm thickness (hereinafter referred to as "approximately 50 µm thickness") is removed by the precision thinning stage.

The precision thinning stage includes a first etching step of supplying a first etching liquid (typically, a hydrofluoric nitric acid aqueous solution) containing hydrofluoric acid and nitric acid to the principal surface to be processed and a second etching step of thereafter supplying a second etching liquid (typically, a TMAH aqueous solution) containing TMAH (tetramethylammonium hydroxide) to the principal surface to be processed. In the example embodiment, the precision thinning stage further includes a third etching step of supplying, after the second etching step, a third etching liquid (typically, ammonia water) containing ammonium hydroxide to the principal surface to be processed.

In the first etching step, for example, the silicon layer 100 (the silicon substrate) is thinned from approximately 50 µm thickness to approximately 10 µm thickness. The first etching step is a high-speed wet etching step of comparatively high etching rate.

The second etching step that is executed after the first etching step is a low-speed etching step of a lower etching rate than the first etching step. In the second etching step, the silicon layer 100 is thinned from approximately 10 µm thickness to approximately 3 µm thickness. A layer thickness of the silicon layer 100 at the end of the second etching step is preferably not more than 4 µm (and not less than 2.5 µm).

The third etching step that is executed after the second etching step is a step of removing the silicon layer 100 with the remaining 3 µm thickness and typically, not just the silicon layer 100 but a thickness portion of a portion of a surface layer of the etching stop layer 101 is removed and, while leaving the etching stop layer 101, the material of the silicon layer 100 on it is removed completely. For example, when an initial thickness of the etching stop layer 101 is approximately 10 nm, a thickness portion of approximately 5 nm of its surface layer may be removed.

The silicon germanium layer constituting the etching stop layer 101 is preferably made as low in germanium composition as possible and made as thin in film thickness as possible. As an example, the etching stop layer 101 can be arranged with an Si_{0.75}Ge_{0.25} layer of approximately 10 nm film thickness. A lattice constant of the silicon layer 100 can thereby be inherited to the silicon active layer 102 via the silicon germanium layer and a crystal defect (a dislocation) due to stress relaxation of the silicon germanium layer can be suppressed. The layer thickness of the etching stop layer 101 is thus preferably not more than 10 nm.

On the other hand, by the germanium composition being low, an etching selectivity of the silicon layer 100 with respect to the etching stop layer 101 cannot be made very high in the third etching step (etching by ammonia water). Etching of the etching stop layer 101 thus occurs unavoidably. The etching stop layer 101 thus preferably has a layer thickness of not less than 5 nm.

When a surface profile of the principal surface when the third etching step is started has a large unevenness, there is a risk of the third etching liquid penetrating through the thin etching stop layer 101 of approximately 5 nm to 10 nm thickness and damaging the silicon active layer 102 in the third etching step. Therefore, the surface profile of the silicon layer 100 must be flattened sufficiently in the state in which the thinning up to the second etching step has ended.

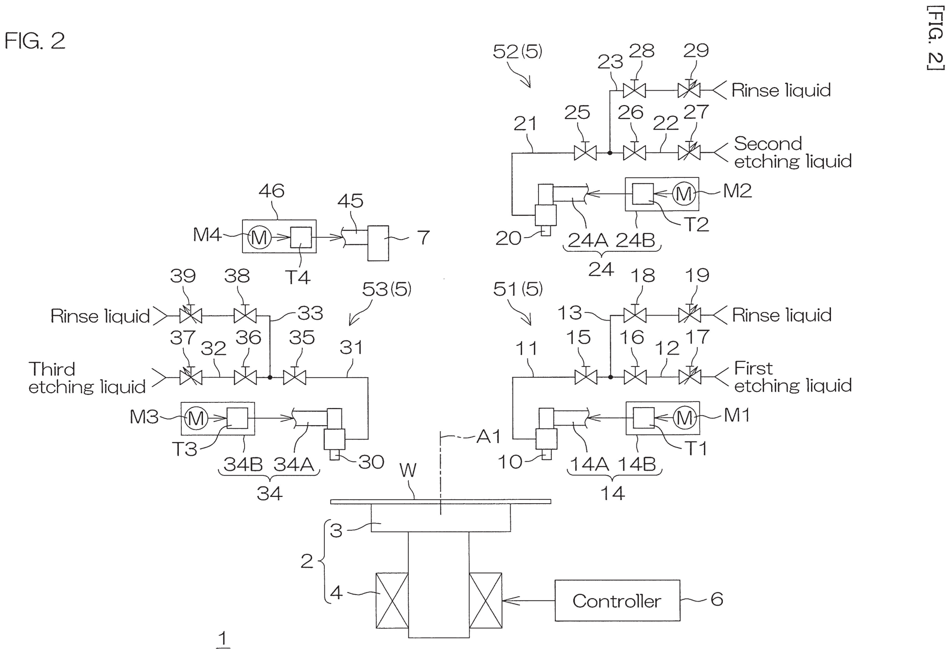

FIG. 2 shows an arrangement example of a substrate processing apparatus 1 arranged to execute the precision thinning stage. The substrate processing apparatus 1 includes a spin chuck 2 that holds and rotates the substrate W, a processing liquid supplying unit 5 that supplies a processing liquid to a principal surface (the principal surface to be processed mentioned above) of the substrate W held by the spin chuck 2, and a controller 6 that controls the spin chuck 2 and the processing liquid supplying unit 5. The processing liquid supplying unit 5 includes a first etching liquid supplying unit 51, a second etching liquid supplying unit 52, and a third etching liquid supplying unit 53 that supply the first etching liquid, the second etching liquid, and the third etching liquid, respectively, to the principal surface of the substrate W held by the spin chuck 2. The substrate processing apparatus 1 further includes a thickness sensor 7 that detects a height of the surface of the substrate W to detect a layer thickness of the layer to be processed.

The spin chuck 2 includes a rotating holder 3 that holds the substrate W to be processed (the bonded substrate mentioned above) in a horizontal orientation with the principal surface to be processed facing upward and is capable of rotating around a rotational axis A1 perpendicular (that is, vertical) to the principal surface and a spin motor 4 that rotates the rotating holder 3 around the rotational axis A1. The rotating holder 3 preferably has a form of a vacuum chuck that suctions and holds a lower surface of the substrate W. However, the rotating holder 3 may instead have a form of a mechanical chuck that includes a holding pin contacting a peripheral end surface of the substrate W. The spin motor 4 is controlled in its rotation/stoppage and rotational speed by the controller 6.

The first etching liquid supplying unit 51 includes a first nozzle 10 that discharges the processing liquid toward the principal surface (an upper surface) of the substrate W held by the spin chuck 2, a first processing liquid piping 11 that is connected to the first nozzle 10, a first etching liquid piping 12 that supplies the first etching liquid to the first processing liquid piping 11, a first rinse liquid piping 13 that supplies a rinse liquid to the first processing liquid piping 11, and a first nozzle moving unit 14 that moves the first nozzle 10. A first processing liquid valve 15 constituted of an opening/closing valve is interposed in the first processing liquid piping 11. The first etching liquid piping 12 is connected between a first etching liquid supply source and the first processing liquid piping 11 and makes the first etching liquid (for example, the hydrofluoric nitric acid aqueous solution), supplied from the first etching liquid supply source to the first nozzle 10, flow. A first etching liquid valve 16 and a first etching liquid flow control valve 17 are interposed in the first etching liquid piping 12. The first etching liquid valve 16 is an opening/closing valve. When the first etching liquid valve 16 is opened, the first etching liquid is discharged from the first nozzle 10 at a flow rate adjusted by the first etching liquid flow control valve 17. The first rinse liquid piping 13 makes the rinse liquid, supplied from a rinse liquid supply source to the first processing liquid piping 11, flow. A first rinse liquid flow control valve 19 that adjusts a flow rate of the rinse liquid and a first rinse liquid valve 18 that is an opening/closing valve are interposed in the first rinse liquid piping 13. The rinse liquid is typically deionized water. However, a rinse liquid of another type such as carbonated water, electrolyzed water, etc., may be used instead.

The first nozzle moving unit 14 includes a first nozzle holder 14A that holds the first nozzle 10 and a first nozzle driving unit 14B that drives the first nozzle holder 14A to move the first nozzle 10. The first nozzle driving unit 14B includes, for example, a first scan motor M1 as a driving source and a first transmission mechanism T1 that transmits a driving force of the first scan motor M1 to the first nozzle holder 14A. The first nozzle driving unit 14B is arranged, for example, to be capable of moving the first nozzle 10 at least in a direction parallel to the principal surface of the substrate W (in this example embodiment, a horizontal direction). More essentially, the first nozzle moving unit 14 is arranged such as to move the first nozzle 10 such that a distance between a liquid landing position, at which the processing liquid discharged from the first nozzle 10 lands on the principal surface of the substrate W, and the rotational axis A1 changes. More specifically, the liquid landing position may move substantially along a rotational radius direction of the substrate W centered at the rotational axis A1. By the liquid landing position of the processing liquid from the first nozzle 10 moving in the rotational radius direction while the substrate W is rotated around the rotational axis A1, the liquid landing position is scanned across the surface of the substrate W. Such a discharge mode of the processing liquid is referred to as "scanning discharge." The first nozzle 10 can also be kept still at a predetermined position and the processing liquid can be discharged with the liquid landing position of the processing liquid on the substrate W being fixed in the rotational radius direction. Such a discharge mode of the processing liquid is referred to as "fixed discharge."

The second etching liquid supplying unit 52 includes a second nozzle 20 that discharges the processing liquid toward the principal surface (the upper surface) of the substrate W held by the spin chuck 2, a second processing liquid piping 21 that is connected to the second nozzle 20, a second etching liquid piping 22 that supplies the second etching liquid to the second processing liquid piping 21, a second rinse liquid piping 23 that supplies the rinse liquid to the second processing liquid piping 21, and a second nozzle moving unit 24 that moves the second nozzle 20. A second processing liquid valve 25 constituted of an opening/closing valve is interposed in the second processing liquid piping 21. The second etching liquid piping 22 is connected between a second etching liquid supply source and the second processing liquid piping 21 and makes the second etching liquid (for example, the TMAH aqueous solution), supplied from the second etching liquid supply source to the second nozzle 20, flow. A second etching liquid valve 26 and a second etching liquid flow control valve 27 are interposed in the second etching liquid piping 22. The second etching liquid valve 26 is an opening/closing valve. When the second etching liquid valve 26 is opened, the second etching liquid is discharged from the second nozzle 20 at a flow rate adjusted by the second etching liquid flow control valve 27. The second rinse liquid piping 23 makes the rinse liquid, supplied from the rinse liquid supply source to the second processing liquid piping 21, flow. A second rinse liquid flow control valve 29 that adjusts a flow rate of the rinse liquid and a second rinse liquid valve 28 that is an opening/closing valve are interposed in the second rinse liquid piping 23.

The second nozzle moving unit 24 includes a second nozzle holder 24A that holds the second nozzle 20 and a second nozzle driving unit 24B that drives the second nozzle holder 24A to move the second nozzle 20. The second nozzle driving unit 24B includes, for example, a second scan motor M2 as a driving source and a second transmission mechanism T2 that transmits a driving force of the second scan motor M2 to the second nozzle holder 24A. The second nozzle driving unit 24B is arranged, for example, to be capable of moving the second nozzle 20 at least in a direction parallel to the principal surface of the substrate W (in this example embodiment, a horizontal direction). More essentially, the second nozzle moving unit 24 is arranged such as to move the second nozzle 20 such that a distance between a liquid landing position, at which the processing liquid discharged from the second nozzle 20 lands on the principal surface of the substrate W, and the rotational axis A1 changes. More specifically, the liquid landing position may move substantially along the rotational radius direction of the substrate W centered at the rotational axis A1. By the liquid landing position of the processing liquid from the second nozzle 20 moving in the rotational radius direction while the substrate W is rotated around the rotational axis A1, the liquid landing position is scanned across the surface of the substrate W. Therefore, scanning discharge and fixed discharge can also be performed by the second nozzle 20.

The third etching liquid supplying unit 53 includes a third nozzle 30 that discharges the processing liquid toward the principal surface (the upper surface) of the substrate W held by the spin chuck 2, a third processing liquid piping 31 that is connected to the third nozzle 30, a third etching liquid piping 32 that supplies the third etching liquid to the third processing liquid piping 31, a third rinse liquid piping 33 that supplies the rinse liquid to the third processing liquid piping 31, and a third nozzle moving unit 34 that moves the third nozzle 30. A third processing liquid valve 35 constituted of an opening/closing valve is interposed in the third processing liquid piping 31. The third etching liquid piping 32 is connected between a third etching liquid supply source and the third processing liquid piping 31 and makes the third etching liquid (for example, the ammonia water), supplied from the third etching liquid supply source to the third nozzle 30, flow. A third etching liquid valve 36 and a third etching liquid flow control valve 37 are interposed in the third etching liquid piping 32. The third etching liquid valve 36 is an opening/closing valve. When the third etching liquid valve 36 is opened, the third etching liquid is discharged from the third nozzle 30 at a flow rate adjusted by the third etching liquid flow control valve 37. The third rinse liquid piping 33 makes the rinse liquid, supplied from the rinse liquid supply source to the third processing liquid piping 31, flow. A third rinse liquid flow control valve 39 that adjusts a flow rate of the rinse liquid and a third rinse liquid valve 38 that is an opening/closing valve are interposed in the third rinse liquid piping 33.

The third nozzle moving unit 34 includes a third nozzle holder 34A that holds the third nozzle 30 and a third nozzle driving unit 34B that drives the third nozzle holder 34A to move the third nozzle 30. The third nozzle driving unit 34B includes, for example, a third scan motor M3 as a driving source and a third transmission mechanism T3 that transmits a driving force of the third scan motor M3 to the third nozzle holder 34A. The third nozzle driving unit 34B is arranged, for example, to be capable of moving the third nozzle 30 at least in a direction parallel to the principal surface of the substrate W (in this example embodiment, a horizontal direction). More essentially, the third nozzle moving unit 34 is arranged such as to move the third nozzle 30 such that a distance between a liquid landing position, at which the processing liquid discharged from the third nozzle 30 lands on the principal surface of the substrate W, and the rotational axis A1 changes. More specifically, the liquid landing position may move substantially along the rotational radius direction of the substrate W centered at the rotational axis A1. By the liquid landing position of the processing liquid from the third nozzle 30 moving in the rotational radius direction while the substrate W is rotated around the rotational axis A1, the liquid landing position is scanned across the surface of the substrate W. Therefore, scanning discharge and fixed discharge can also be performed by the third nozzle 30.

The thickness sensor 7 is held by a sensor holder 45. The sensor holder 45 is driven by a sensor driving unit 46 and the thickness sensor 7 is thereby moved along the rotational radius direction of the substrate W. A position of detection by the thickness sensor 7 is thereby moved in the rotational radius direction of the substrate W. A relationship of a detection value of the thickness sensor 7 with respect to the detection position of the thickness sensor 7 thus expresses a surface profile of the substrate W. A surface profile monitoring unit that monitors the surface profile is thus arranged by the thickness sensor 7, the sensor driving unit 46, etc. The sensor driving unit 46 typically includes a fourth scan motor M4 and a fourth transmission mechanism T4 that transmits a driving force of the fourth scan motor M4 to the sensor holder 45.

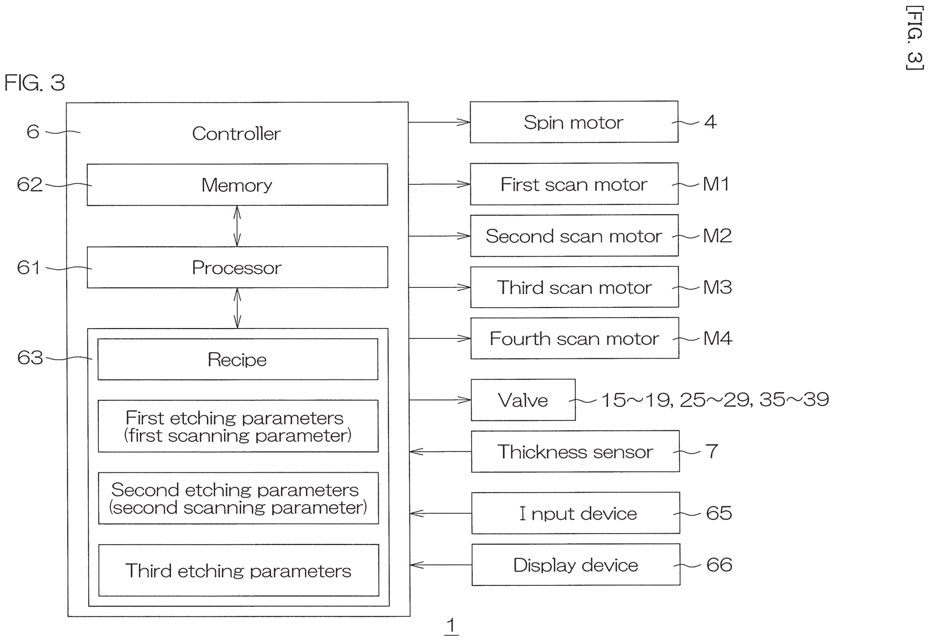

FIG. 3 is a block diagram for describing an electrical arrangement of the substrate processing apparatus 1. The controller 6 includes a processor 61 and a memory 62 and the processor 61 executes a program stored in the memory 62 to control respective portions of the substrate processing apparatus 1 and control a processing performed on the substrate W. Specifically, the controller 6 controls driving/stoppage and rotational speeds of the spin motor 4, the first scan motor M1, the second scan motor M2, the third scan motor M3, and the fourth scan motor M4. Also, the controller 6 controls opening/closing of the first processing liquid valve 15, the first etching liquid valve 16, the first rinse liquid valve 18, the second processing liquid valve 25, the second etching liquid valve 26, the second rinse liquid valve 28, the third processing liquid valve 35, the third etching liquid valve 36, and the third rinse liquid valve 38. Further, the controller 6 may be arranged such as to be capable of controlling opening degrees (that is, flow rates) of the first etching liquid flow control valve 17, the first rinse liquid flow control valve 19, the second etching liquid flow control valve 27, the second rinse liquid flow control valve 29, the third etching liquid flow control valve 37, and the third rinse liquid flow control valve 39. Also, an output signal of the thickness sensor 7 is input into the controller 6. Further, an input device 66 and a display device 65 that provide a man machine interface are connected to the controller 6. By using the input device 66 and the display device 65, a user can input various commands into the controller 6 and check a state of the substrate processing apparatus 1.

The controller 6 further includes an auxiliary storage device 63 that is a storage device of large capacity. A recipe that defines substrate processing conditions can be registered in the auxiliary storage device 63. Also, various parameter groups for etching processing, that is, etching parameters can be set and registered in the auxiliary storage device 63. Specifically, first etching parameters for the first etching step, second etching parameters for the second etching step, and the third etching parameters for the third etching step can be set and registered.

The etching parameters include parameters related to discharge conditions, a concentration of an etching liquid, a temperature of the etching liquid, etc. The parameters related to discharge conditions may include a parameter defining a discharge flow rate of the etching liquid, a parameter defining a discharge timing of the etching liquid, a parameter related to a moving speed of a nozzle (in other words, a moving speed of a liquid landing position), a parameter related to a rotational speed of the substrate W, etc. For example, the parameters related to discharge conditions may have a form of a table that defines one or more among the moving speed of the nozzle, the discharge flow rate of the etching liquid, and the substrate rotational speed with respect to a position of the nozzle in the rotational radius direction (in other words, the liquid landing position).

By adjusting these etching parameters, an etching profile, which is a relationship of etching amount (etching depth) with respect to rotational radius direction position (distance from the rotational axis A1) on the principal surface of the substrate W, can be adjusted.

Here, the "etching profile" refers to the surface profile of the principal surface of the substrate W after an etching processing when the principal surface of the substrate W is completely flat. More specifically, the etching profile expresses a relationship of the etching depth with respect to the rotational radius direction position on the substrate principal surface. The surface profile refers to a relationship of the height of the principal surface of the substrate W with respect to the rotational radius direction position on the principal surface. In actuality, the principal surface of the substrate W when the substrate processing of the precision thinning stage is started is not a completely flat surface. Therefore, the surface profile after the etching processing has a shape with which the etching profile is overlapped with the surface profile before the etching processing.

In the following, the surface profile before start of the first etching step is referred to as an "initial surface profile." Also, the surface profile after end of the first etching step and before the second etching step is started is referred to as a "first surface profile." Further, the surface profile after end of the second etching step and before the third etching step is started is referred to as a "second surface profile." Further, the etching profile in the first etching step is referred to as a "first etching profile." The first etching profile is a difference between the first surface profile and the initial surface profile. Similarly, the etching profile in the second etching step is referred to as a "second etching profile." The second etching profile is a difference between the second surface profile and the first surface profile.

In the first etching step, for example, scanning discharge of the first etching liquid is performed. That is, the first etching step includes a first scanning step of moving the liquid landing position of the first etching liquid on the substrate principal surface such that the distance between the liquid landing position and the rotational axis A1 changes with elapse of time. In this case, the first etching parameters include a first scanning parameter that defines the change in liquid landing position in the first scanning step. The first scanning parameter typically has a form of a table that defines the rotational radius direction position of the first nozzle 10 with respect to the elapse of time. By variably setting the first scanning parameter, the first etching profile can be adjusted in various shapes.

Similarly, in the second etching step, for example, scanning discharge of the second etching liquid is performed. That is, the second etching step includes a second scanning step of moving the liquid landing position of the second etching liquid on the substrate principal surface such that the distance between the liquid landing position and the rotational axis A1 changes with the elapse of time. In this case, the second etching parameters include a second scanning parameter that defines the change in liquid landing position in the second scanning step. The second scanning parameter typically has a form of a table that defines the rotational radius direction position of the second nozzle 20 with respect to the elapse of time. By variably setting the second scanning parameter, the second etching profile can be adjusted in various shapes.

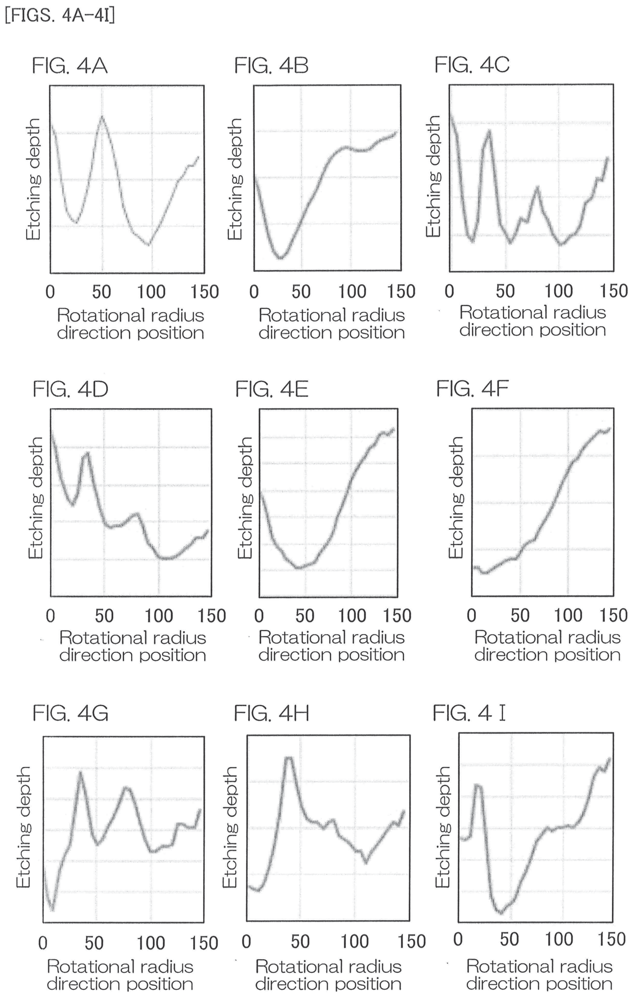

FIG. 4A to FIG. 4I show examples of various etching profiles that can be set by adjustment of the etching parameters in the case where the hydrofluoric nitric acid aqueous solution is used as the first etching liquid. Various etching profiles can also be set similarly in regard to the second etching liquid.

By appropriately setting the etching parameters, an etching profile that is as flat as possible can be set. Also, by setting of the etching parameters (particularly the scanning parameter), a peak portion of the etching profile (a region in which the etching rate is relatively low and the etching depth becomes shallow) and a valley portion of the etching profile (a region in which the etching rate is relatively high and the etching depth becomes deep) can be set intentionally at any rotational radius direction position.

An achievable amplitude of the etching profile depends on a magnitude of the etching rate of the etching liquid used. The amplitude of the etching profile can be made large with an etching liquid of high etching rate, and the achievable amplitude of the etching profile is small with an etching liquid of low etching rate. Oppositely, a minimum amplitude of the etching profile achievable with an etching liquid of high etching rate is larger than a minimum amplitude of the etching profile achievable with an etching liquid of low etching rate.

More specifically, the etching rate of the hydrofluoric nitric acid that is an example of the first etching liquid is higher than the etching rate of the TMAH aqueous solution that is an example of the second etching liquid. Therefore, the etching profile of the etching processing by the first etching liquid is generally larger in amplitude than the etching profile of the etching processing by the second etching liquid.

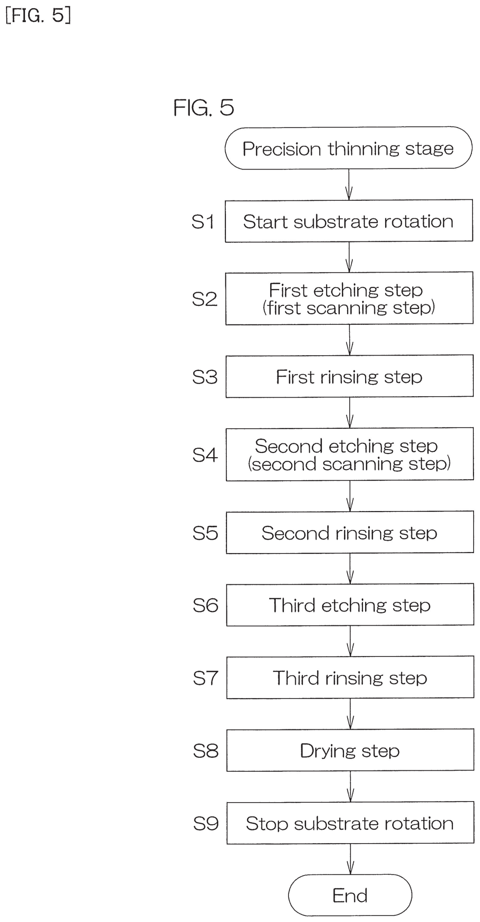

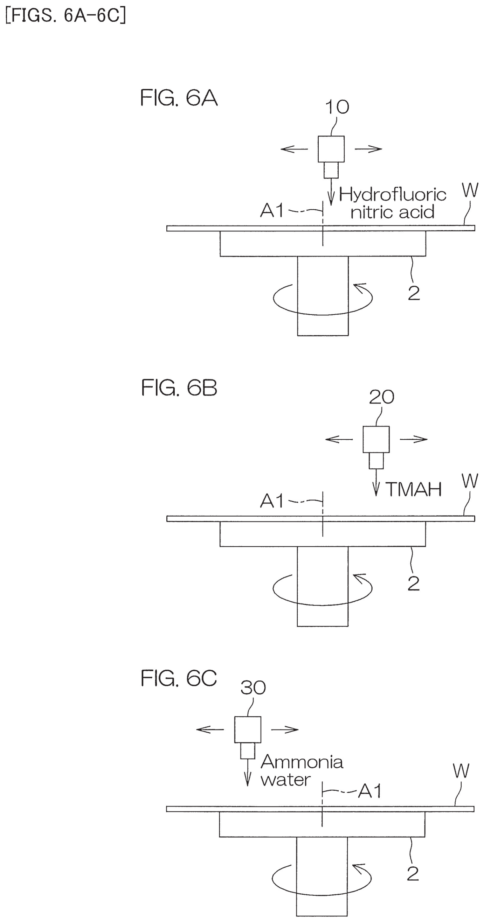

FIG. 5 is a flow diagram showing an example of the substrate processing of the precision thinning stage. Also, FIG. 6A, FIG. 6B, and FIG. 6C show conditions of main steps. The substrate W that has undergone the high-speed thinning stage is transferred by a substrate transfer robot to be held by the spin chuck 2. The controller 6 then drives the spin motor 4 and rotates the substrate W around the rotational axis A1 and starts a substrate rotating step (step S1).

In the state in which the substrate rotating step is being executed, the controller 6 executes the first etching step (step S2; see FIG. 6A). The first etching step is the step in which the first etching liquid (typically, the hydrofluoric nitric acid aqueous solution) containing hydrofluoric acid and nitric acid is supplied to the principal surface of the substrate W. In the first etching step, the controller 6 applies the first etching parameters that have been set in advance for the first etching step. Specifically, the controller 6 controls the spin motor 4, the first etching liquid valve 16, the first etching liquid flow control valve 17, the first scan motor M1, etc., in accordance with the first etching parameters. The controller 6 then opens the first processing liquid valve 15 and makes the first etching liquid be discharged to the principal surface of the substrate W from the first nozzle 10. Thereby, typically by the scanning discharge from the first nozzle 10 (the first scanning step), the first etching liquid is supplied to the principal surface of the substrate W and the principal surface of the substrate W is etched by the first etching liquid. Consequently, the etching processing of the principal surface of the substrate W is performed in accordance with the first etching profile corresponding to the first etching parameters.

When the first etching step is ended, the controller 6 closes the first etching liquid valve 16 and stops the supplying of the first etching liquid and, while continuing the substrate rotating step, executes a first rinsing step (step S3). The first rinsing step is a processing of supplying the rinse liquid to the principal surface of the substrate W and making the first etching liquid on the principal surface of the substrate W be replaced with the rinse liquid and washed away outside the substrate W. Specifically, the spin motor 4, the first rinse liquid valve 18, the first rinse liquid flow control valve 19, and the first scan motor M1, etc., are controlled. Thereby, the rinse liquid is discharged onto the principal surface of the substrate W from the first nozzle 10. The discharge in this case may be a fixed discharge with which a liquid landing position of the rinse liquid is fixed in a vicinity of the rotational axis A1 or may be a scanning discharge. After the rinsing processing of a predetermined time, the controller 6 closes the first rinse liquid valve 18 and the first processing liquid valve 15 and ends the first rinsing step.

Next, in the state in which the substrate rotating step is being executed, the controller 6 executes the second etching step (step S4; see FIG. 6B). The second etching step is the step in which the second etching liquid (typically, the TMAH aqueous solution) containing TMAH is supplied to the principal surface of the substrate W. In the second etching step, the controller 6 applies the second etching parameters that have been set in advance for the second etching step. Specifically, the controller 6 controls the spin motor 4, the second etching liquid valve 26, the second etching liquid flow control valve 27, the second scan motor M2, etc., in accordance with the second etching parameters. The controller 6 then opens the second processing liquid valve 25 and makes the second etching liquid be discharged to the principal surface of the substrate W from the second nozzle 20. Thereby, typically by the scanning discharge from the second nozzle 20 (the second scanning step), the second etching liquid is supplied to the principal surface of the substrate W and the principal surface of the substrate W is etched by the second etching liquid. Consequently, the etching processing of the principal surface of the substrate W is performed in accordance with the second etching profile corresponding to the second etching parameters.

When the second etching step is ended, the controller 6 closes the second etching liquid valve 26 and stops the supplying of the second etching liquid and, while continuing the substrate rotating step, executes a second rinsing step (step S5). The second rinsing step is a processing of supplying the rinse liquid to the principal surface of the substrate W and making the second etching liquid on the principal surface of the substrate W be replaced with the rinse liquid and washed away outside the substrate W. Specifically, the spin motor 4, the second rinse liquid valve 28, the second rinse liquid flow control valve 29, and the second scan motor M2, etc., are controlled. Thereby, the rinse liquid is discharged onto the principal surface of the substrate W from the second nozzle 20. The discharge in this case may be a fixed discharge with which a liquid landing position of the rinse liquid is fixed in a vicinity of the rotational axis A1 or may be a scanning discharge. After the rinsing processing of a predetermined time, the controller 6 closes the second rinse liquid valve 28 and the second processing liquid valve 25 and ends the second rinsing step.

Next, in the state in which the substrate rotating step is being executed, the controller 6 executes the third etching step (step S6; see FIG. 6C). The third etching step is the step in which the third etching liquid (typically, the ammonia water) containing ammonium hydroxide is supplied to the principal surface of the substrate W. In the third etching step, the controller 6 applies the third etching parameters that have been set in advance for the third etching step. Specifically, the controller 6 controls the spin motor 4, the third etching liquid valve 36, the third etching liquid flow control valve 37, the third scan motor M3, etc., in accordance with the third etching parameters. The controller 6 then opens the third processing liquid valve 35 and makes the third etching liquid be discharged to the principal surface of the substrate W from the third nozzle 30. Thereby, typically by the scanning discharge from the third nozzle 30 (the third scanning step), the third etching liquid is supplied to the principal surface of the substrate W and the principal surface of the substrate W is etched by the third etching liquid.

When the third etching step is ended, the controller 6 closes the third etching liquid valve 36 and stops the supplying of the third etching liquid and, while continuing the substrate rotating step, executes a third rinsing step (step S7). The third rinsing step is a processing of supplying the rinse liquid to the principal surface of the substrate W and making the third etching liquid on the principal surface of the substrate W be replaced with the rinse liquid and washed away outside the substrate W. Specifically, the spin motor 4, the third rinse liquid valve 38, the third rinse liquid flow control valve 39, and the third scan motor M3, etc., are controlled. Thereby, the rinse liquid is discharged onto the principal surface of the substrate W from the third nozzle 30. The discharge in this case may be a fixed discharge with which a liquid landing position of the rinse liquid is fixed in a vicinity of the rotational axis A1 or may be a scanning discharge. After the rinsing processing of a predetermined time, the controller 6 closes the third rinse liquid valve 38 and the third processing liquid valve 35 and ends the third rinsing step.

Thereafter, the controller 6 performs a drying step for removing the liquid on the substrate W and drying the substrate W (step S8). The drying step is typically a spin drying processing of rotating upon accelerating the rotational speed of the spin chuck 2 to a drying rotational speed.

When the drying step is ended, the controller 6 stops the rotation of the spin chuck 2 and ends the substrate rotating step (step S9)). Thereafter, the processed substrate W is carried out by the substrate transfer robot.

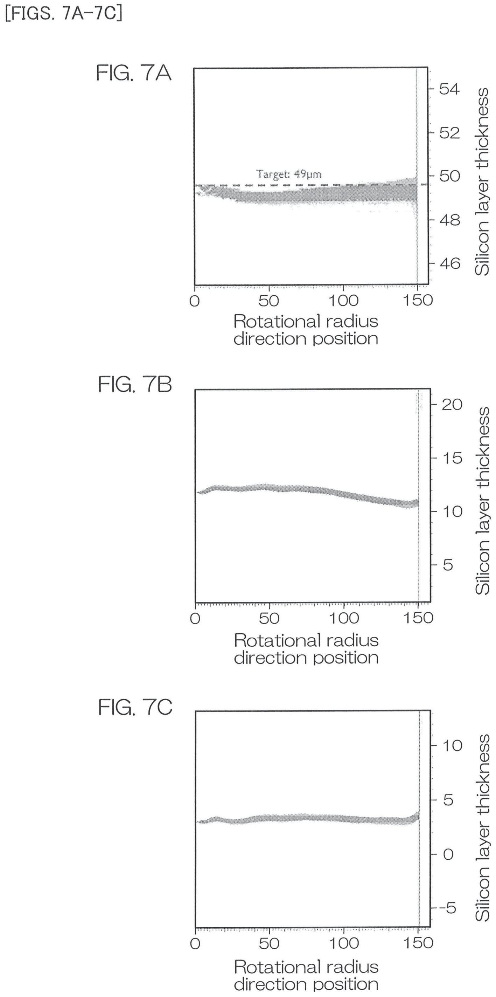

FIG. 7A shows an example of the surface profile of the principal surface of the substrate W for which the high-speed thinning stage has ended, that is, the initial surface profile before the first etching step is started. The abscissa is the rotational radius direction position (the distance from the rotational axis A1) and the ordinate represents the layer thickness of the silicon layer 100 that is the object of removal. Since there is some variation in regard to a circumferential direction position around the rotational axis A1 as well, the surface profile has a form that is not line-shaped but is band-shaped. Here, a target layer thickness in the high-speed thinning stage is set to 49 µm.

FIG. 7B represents an example of the surface profile (the first surface profile) after the first etching step using the hydrofluoric nitric acid aqueous solution (the first etching liquid). The first surface profile is an overlap of the initial surface profile and the first etching profile. In other words, the difference between the first surface profile and the initial surface profile is the first etching profile.

FIG. 7C shows an example of the surface profile (the second surface profile) after the second etching step using the TMAH aqueous solution (the second etching liquid) . The second surface profile is an overlap of the first surface profile and the second etching profile. In other words, the difference between the second surface profile and the first surface profile is the second etching profile. The second surface profile is an overlap of the initial surface profile, the first etching profile, and the second etching profile.

In this example embodiment, the etching conditions (the first etching parameters) of the first etching step and the etching conditions (the second etching parameters) of the second etching step are set such as to make the second surface profile as flat as possible. More specifically, the first etching parameters (particularly the first scanning parameter) and the second etching parameters (particularly the second scanning parameter) are adjusted and set such that the second surface profile will be flatter than the first surface profile. By adjusting the first etching parameters, the first etching profile is adjusted and by adjusting the second etching parameters, the second etching profile is adjusted. The adjustment of the first etching parameters can be reworded as the adjustment of the first etching profile and the adjustment of the second etching parameters can be reworded as the adjustment of the second etching profile.

As mentioned above, the etching rate of the hydrofluoric nitric acid aqueous solution (the first etching liquid) is comparatively high and thus, the first etching profile has a comparatively large amplitude accordingly. It is thus difficult for a flatness of the required level to be achieved in the first surface profile (see FIG. 7B). On the other hand, the etching rate of the TMAH aqueous solution (the second etching liquid) is comparatively low and thus the second etching profile can be made to be of a shape of small amplitude. But on the other hand, the second etching profile cannot be made to have a large amplitude. A general shape of the second surface profile is thus determined by the first etching step.

It can therefore be considered that by performing the first etching step with the first etching parameters being set such that the first surface profile will be flattest and thereafter performing the second etching step, the second surface profile will have a satisfactory flatness. However, this process that is considered to be reasonable was found by research by the present inventors to not necessarily achieve the best (the flattest) second surface profile in the final stage. More specifically, a combination of first etching parameters with which the first surface profile becomes the flattest and second etching parameters with which, given such first etching parameters, the second surface profile becomes the flattest is not necessarily an optimal solution.

The present inventors thus considered adjusting the first surface profile (that is, adjusting the first etching profile) based on a second etching profile realizable by adjustment of the second etching parameters and thereby obtaining a second surface profile of high flatness. And instead of setting the conditions of the first etching step and the second etching step individually and adjusting such as to make the surface profile as flat as possible in each step, it was found that, while setting first etching conditions with which the first surface profile does not necessarily become flattest, the first etching conditions and second etching conditions can be adjusted such that the second surface profile becomes flattest.

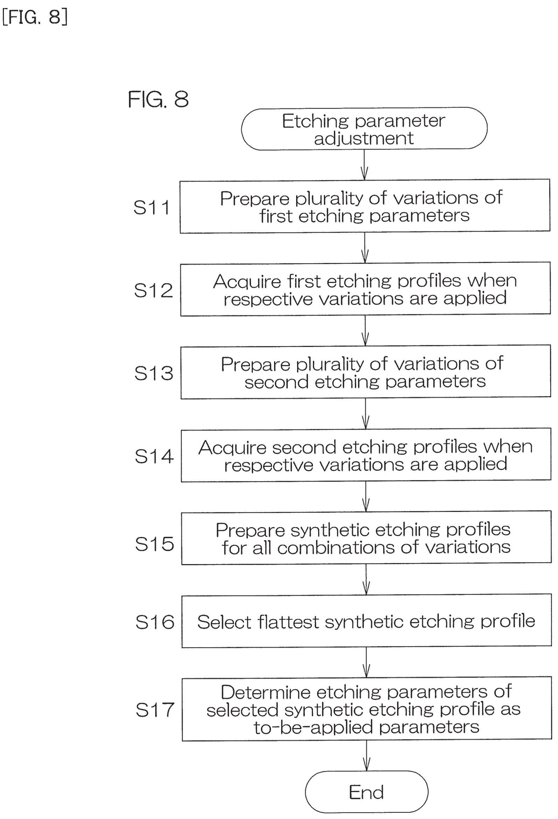

FIG. 8 shows an example of a flow of the adjustment of the etching parameters.

A plurality of sets of variations of the first etching parameters (parameter group) for the first etching step are prepared (step S11). The first etching profiles when the respective variations of the first etching parameters are applied to perform the first etching step on the principal surface of the substrate W that has undergone the high-speed thinning stage are then acquired by actual measurements or simulations (step S12). In the case of performing this by actual measurements, each first etching profile can be determined by using the thickness sensor 7 to measure the first surface profile and the surface profile of the principal surface of the substrate W before the first etching step (the initial surface profile) and computing the difference between the two.

Further, a plurality of sets of variations of the second etching parameters (parameter group) for the second etching step are prepared (step S13). The second etching profiles when the respective variations of the second etching parameters are applied to perform the second etching step on the principal surface of the substrate W are then acquired by actual measurements or simulations (step S14). In the case of performing this by actual measurements, each second etching profile can be determined by using the thickness sensor 7 to measure the second surface profile and the surface profile of the principal surface of the substrate W before the second etching step and computing the difference between the two. Although in this case, the substrate W is preferably the substrate W that has undergone the first etching step, it may instead be the substrate W that has undergone the high-speed thinning stage but has not undergone the first etching step.

Next, synthetic etching profiles are prepared by overlapping the first etching profiles and the second etching profiles (step S15). The synthetic etching profiles are prepared for all combinations of the plurality of first etching profiles obtained from the plurality of variations of the first etching parameters and the plurality of second etching profiles obtained from the plurality of variations of the second etching parameters.

From among the plurality of synthetic etching profiles thus prepared, the synthetic etching profile that is flattest for the substrate W as a whole is selected (step S16). In this process, the synthetic etching profile with a flatness of not more than a predetermined value (for example, of 1.5 µm) is selected. The combination of the first etching parameters and the second etching parameters corresponding to the selected synthetic etching profile is determined as the etching parameters to be applied to the substrate processing (step S17).

When the initial surface profile has a sufficient flatness, by the synthetic etching profile having the flatness of not more than the predetermined value, the principal surface of the substrate W after the second etching step can be made to have the flatness not more than the predetermined value (for example, of 1.5 µm) accordingly. Thus, by respectively applying the first etching parameters and the second etching parameters determined as described above to the first etching step and the second etching step, the principal surface of the substrate W after the second etching step can be made to have the flatness not more than the predetermined value.

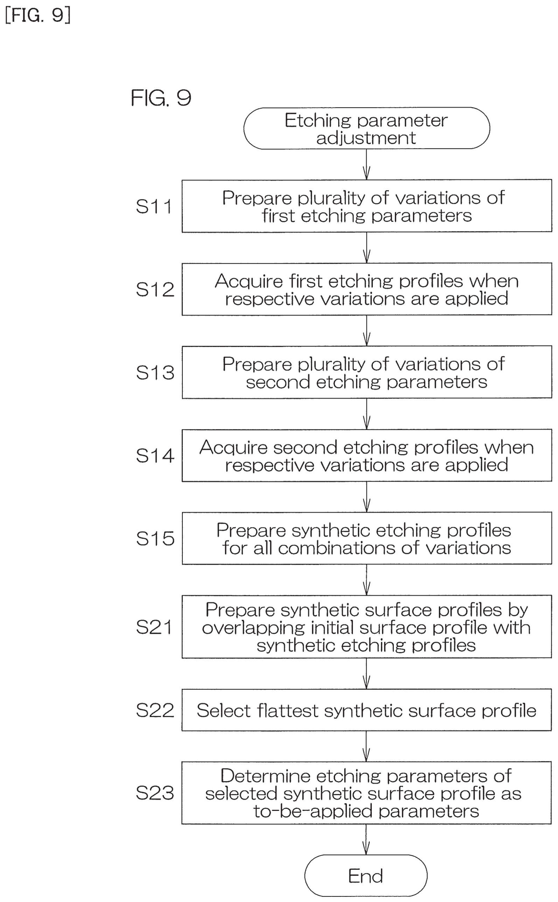

FIG. 9 shows another example of the flow of the adjustment of the etching parameters. Steps that are the same as the respective steps in FIG. 8 are provided with the same reference signs.

With this example, the initial surface profile is overlapped with the plurality of synthetic etching profiles obtained in step S15 to determine a plurality of synthetic surface profiles corresponding to the second surface profile (step S21). The flattest synthetic surface profile for the substrate as a whole is then selected (step S22). In this process, the synthetic surface profile with a flatness of not more than a predetermined value (for example, of 1.5 µm) is selected. The combination of the first etching parameters and the second etching parameters corresponding to the synthetic etching profile when the selected synthetic surface profile is obtained is determined as the etching parameters to be applied to the substrate processing (step S23). When the flatness of the initial surface profile is insufficient, the surface profile after the second etching step can be optimized by determining the etching parameters on a basis of a flatness of the synthetic surface profile.

The synthetic surface profile is the surface profile in which the first etching profile and the second etching profile are overlapped with the initial surface profile and, as mentioned above, corresponds to the second surface profile. The first etching parameters and the second etching parameters are thus determined such that the synthetic surface profile will have the flatness not more than the predetermined value (for example, of 1.5 µm). By respectively applying the first etching parameters and the second etching parameters thus determined to the first etching step and the second etching step, the principal surface of the substrate W after the second etching step can be made to have the flatness not more than the predetermined value (for example, of 1.5 µm).

One of the etching parameters that exerts a large influence on the etching profile is the scanning parameter. As mentioned above, the first etching parameters include the first scanning parameter and the second etching parameters include the second scanning parameter. The scanning parameter is a parameter that defines the change in time of the liquid landing position in the scanning step. That is, the scanning parameter defines the change in the liquid landing position with respect to the elapse of time. More specifically, the scanning parameter defines the change in the position of the moving nozzle with the elapse of time. By appropriately adjusting the combination of the first scanning parameter and the second scanning parameter, the surface profile of the principal surface of the substrate W after the second etching step can be made to have the flatness not more than the predetermined value (for example, of 1.5 µm).

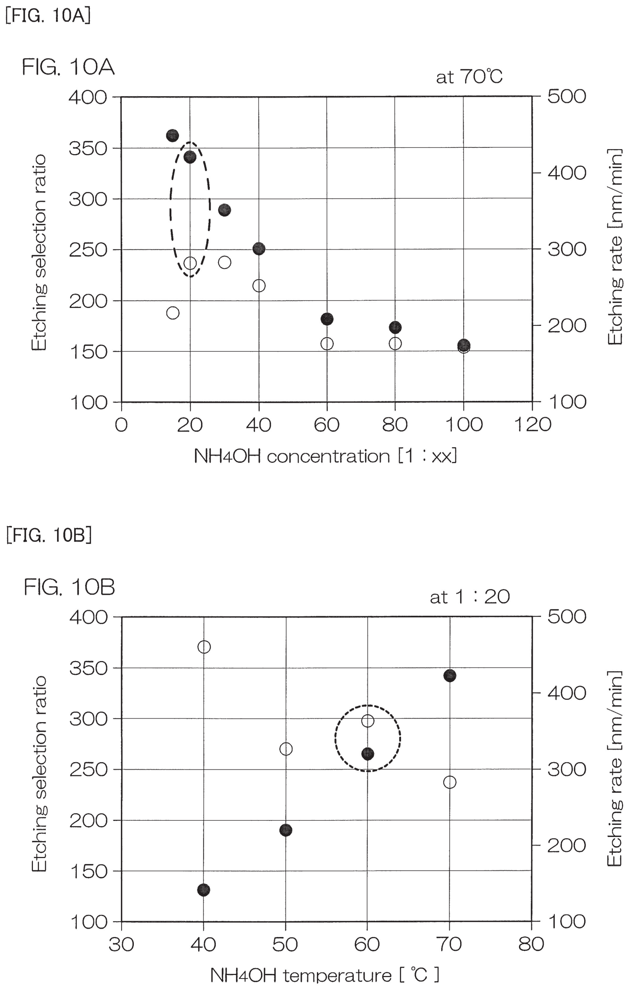

FIG. 10A and FIG. 10B are diagrams for describing an example of a feature of the third etching step. A purpose of the third etching step is to remove all of the silicon layer 100 remaining on the etching stop layer 101, which is the silicon germanium layer, without penetrating through the etching stop layer 101. It is thus preferable that the etching selectivity of silicon with respect to silicon germanium is as high as possible and, for example, is preferably not less than 150 and more preferably not less than 250. Also, for shortening of processing time, an etching rate of the silicon layer 100 is preferably as high as possible and, for example, is preferably not less than 200 nm/minute and more preferably not less than 300 nm/minute.

FIG. 10A shows, for a case of selectively etching silicon by ammonia water that is an example of the third etching liquid, results of examining relationships of etching selection ratio (left ordinate) and etching rate (right ordinate) versus concentration of ammonium hydroxide (NH₄OH) (ammonium hydroxide : water). The abscissa is a proportion of water when a proportion of ammonium hydroxide is set to 1. The etching selection ratio is a ratio of the etching rate of Si with respect to the etching rate of Si_{0.75}Ge_{0.25} (the same applies to FIG. 10B described next). A temperature of the ammonia water was set to 70°C. In the figure, the etching selection ratio is represented by "o" and the etching rate is represented by "•." The etching rate is higher the higher the concentration. On the other hand, the etching selection ratio exhibits an increasing trend in accordance with an increase in concentration up to a vicinity of ammonium hydroxide : water = 1:30, hardly changes in a range of ammonium hydroxide : water = 30 to 20, and shows a decreasing trend in a concentration range higher than ammonium hydroxide : water = 1:20.

FIG. 10B shows, for a case of selectively etching silicon by ammonia water with a concentration of ammonium hydroxide : water = 1:20, results of examining relationships of etching selection ratio (left ordinate) and etching rate (right ordinate) versus temperature of the ammonia water. The abscissa is the temperature of the ammonia water. As in FIG. 10A, the etching selection ratio is represented by "o" and the etching rate is represented by "•." The etching rate is higher the higher the temperature. On the other hand, the etching selection ratio is in a decreasing trend up to 50°C, changes to an increasing trend in a temperature range exceeding 50°C, becomes maximum near 60°C, and is in a decreasing trend again in a temperature range exceeding 60°C.

Thus, for example, by using ammonia water of ammonium hydroxide : water = 1:20 and 60°C as the third etching liquid, an etching rate of not less than 300 nm/minute and an etching selection ratio of not less than 250 can be achieved.

By using the ammonia water that has thus been set appropriately in concentration and temperature as the third etching liquid and performing the third etching step, all of the silicon layer 100 remaining on the etching stop layer 101 constituted of the silicon germanium layer can be removed while suppressing film loss of the etching stop layer 101. For example, the film loss of the etching stop layer 101 can be made not more than 5 nm.

Although example embodiments of the present invention have been described above, the present invention may be implemented in yet other modes.

For example, although with each of the example embodiments described above, a case where the high-speed thinning stage includes the grinding step and the polishing step has been mainly described, the polishing step may be omitted.

Also, the precision thinning stage may include a dry etching step before the first etching step.

While example embodiments of the present invention have been described in detail above, these are merely specific examples used to clarify the technical contents of the present invention, and the present invention should not be interpreted as being limited only to these specific examples, and the scope of the present invention shall be limited only by the appended claims.

### Reference Signs List

- 1 :: substrate processing apparatus
- 2 :: spin chuck
- 3 :: rotating holder
- 4 :: spin motor
- 5 :: processing liquid supplying unit
- 6 :: controller
- 7 :: thickness sensor
- 10 :: first nozzle
- 11 :: first processing liquid piping
- 12 :: first etching liquid piping
- 13 :: first rinse liquid piping
- 14 :: first nozzle moving unit
- 15 :: first processing liquid valve
- 16 :: first etching liquid valve
- 18 :: first rinse liquid valve
- 20 :: second nozzle
- 21 :: second processing liquid piping
- 22 :: second etching liquid piping
- 23 :: second rinse liquid piping
- 24 :: second nozzle moving unit
- 25 :: second processing liquid valve
- 26 :: second etching liquid valve
- 28 :: second rinse liquid valve
- 30 :: third nozzle
- 31 :: third processing liquid piping
- 32 :: third etching liquid piping
- 33 :: third rinse liquid piping
- 34 :: third nozzle moving unit
- 35 :: third processing liquid valve
- 36 :: third etching liquid valve
- 38 :: third rinse liquid valve
- 45 :: sensor holder
- 46 :: sensor driving unit
- 51 :: first etching liquid supplying unit
- 52 :: second etching liquid supplying unit
- 53 :: third etching liquid supplying unit
- 61 :: processor
- 62 :: memory
- 63 :: auxiliary storage device
- 65 :: display device
- 66 :: input device
- 100 :: silicon layer
- 101 :: etching stop layer
- 102 :: silicon active layer
- 103 :: multilayer wiring layer
- 104 :: buried power rail
- 200 :: silicon substrate
- 201 :: insulating layer
- 300 :: adhesive layer
- a1 :: rotational axis
- m1 :: first scan motor
- m2 :: second scan motor
- m3 :: third scan motor
- m4 :: fourth scan motor
- w :: substrate (bonded substrate)
- w1 :: first silicon wafer
- w2 :: second silicon wafer

## Claims

1. A substrate processing method comprising:
a substrate rotating step of rotating a substrate, having a principal surface that has been ground or polished for substrate thinning, around a rotational axis perpendicular to the principal surface;
a first etching step of supplying a first etching liquid that contains hydrofluoric acid and nitric acid to the principal surface during execution of the substrate rotating step; and
a second etching step of supplying a second etching liquid that contains TMAH (tetramethylammonium hydroxide) to the principal surface during execution of the substrate rotating step after the first etching step;
wherein a second etching parameter applied in the second etching step is adjusted such as to flatten a first surface profile formed on the principal surface resulted by the first etching step.

2. The substrate processing method according to Claim 1, wherein
a first etching profile with respect to the principal surface by the first etching step is variable by variable setting of a first etching parameter applied in the first etching step,
a second etching profile with respect to the principal surface by the second etching step is variable by variable setting of the second etching parameter applied in the second etching step, and
the first etching parameter and the second etching parameter are adjusted such that a second surface profile formed on the principal surface resulted by performing the first etching step and the second etching step on the substrate successively has a flatness not more than a predetermined value.

3. The substrate processing method according to Claim 2, wherein the first etching parameter and the second etching parameter are adjusted such that a synthetic etching profile in which the first etching profile and the second etching profile are overlapped has a flatness not more than a predetermined value.

4. The substrate processing method according to Claim 2, wherein the first etching parameter and the second etching parameter are adjusted such that a synthetic surface profile in which an initial surface profile of the principal surface before the first etching step, the first etching profile and the second etching profile are overlapped has a flatness not more than a predetermined value.

5. The substrate processing method according to any one of Claims 2 to 4, wherein
the first etching step includes a first scanning step of moving a liquid landing position of the first etching liquid on the principal surface such that a distance between the liquid landing position and the rotational axis changes with elapse of time, and
the first etching parameter includes a first scanning parameter that defines the change in the liquid landing position in the first scanning step.

6. The substrate processing method according to any one of Claims 1 to 5, wherein
the second etching step includes a second scanning step of moving a liquid landing position of the second etching liquid on the principal surface such that a distance between the liquid landing position and the rotational axis changes with elapse of time, and
the second etching parameter includes a second scanning parameter that defines the change in the liquid landing position in the second scanning step.

7. The substrate processing method according to any one of Claims 1 to 6, wherein a second surface profile of the principal surface after the second etching step has a flatness of not more than 1.5 µm.

8. The substrate processing method according to any one of Claims 1 to 7, wherein the principal surface is a surface where a silicon layer is exposed.

9. The substrate processing method according to Claim 8, wherein the substrate has a silicon germanium layer and the silicon layer that is laminated on the silicon germanium layer.

10. The substrate processing method according to Claim 9, further comprising a third etching step of supplying a third etching liquid that contains ammonium hydroxide to the principal surface during execution of the substrate rotating step after the second etching step.

11. The substrate processing method according to Claim 10, wherein a layer thickness of the silicon layer at an end of the second etching step is not more than 4 µm.

12. The substrate processing method according to Claim 10 or 11, wherein a layer thickness of the silicon germanium layer at an end of the third etching step is not more than 10 nm.

13. The substrate processing method according to any one of Claims 10 to 12, wherein a concentration of the ammonium hydroxide in the third etching liquid and a temperature of the third etching liquid are set such that, in the third etching step, an etching rate of the silicon layer is not less than 200 nm/minute and an etching selection ratio of silicon with respect to silicon germanium is not less than 150.
